# EUROPÄISCHE PATENTSCHRIFT

(11) **EP 2 694 712 B1**
(45) Veröffentlichungstag und Bekanntmachung des Hinweises auf die Patenterteilung: **26.11.2014**
(21) Anmeldenummer: 12718091.7
(22) Anmeldetag: 23.03.2012
(51) Int. Cl.: D03D 1/00, H01L 51/52, H01L 51/44

(54) **ELEKTRODENSUBSTRAT SOWIE FLÄCHIGE OPTOELEKTRONISCHE VORRICHTUNG**
ELECTRODE SUBSTRATE AND PLANAR OPTOELECTRONIC DEVICE
SUBSTRAT D'ÉLECTRODE ET DISPOSITIF OPTOÉLECTRONIQUE BIDIMENSIONNEL

(30) Priorität: 08.04.2011 DE 102011016454; 10.05.2011 DE 102011050250
(43) Veröffentlichungstag der Anmeldung: 12.02.2014
(73) Patentinhaber: Sefar AG, 9425 Thal (CH)
(72) Erfinder: CHABRECEK, Peter, CH-9306 Freidorf (CH); SONDEREGGER, Uriel, CH-9424 Rheineck (CH)
(74) Vertreter: Behrmann, Niels
(86) Internationale Anmeldenummer: PCT/EP2012/055175
(87) Internationale Veröffentlichungsnummer: WO 2012/136488

(56) Entgegenhaltungen:
- WO-A1-2005/067042
- DE-U1-202009 005 751
- US-A1- 2009 166 877
- US-A1- 2010 208 445

## Beschreibung

Die vorliegende Erfindung betrifft ein Elektrodensubstrat nach dem Oberbegriff des Hauptanspruchs, wie es aus der DE 20 2009 005 751 U1 bekannt ist. Ferner betrifft die vorliegende Erfindung eine flächige optoelektronische Vorrichtung, insbesondere organische optoelektronische Vorrichtung, unter Nutzung eines solchen flächigen Elektrodensubstrats, sowie ein Verfahren zum Herstellen eines Elektrodensubstrats.

Ein aus dem Stand der Technik bekanntes Elektrodensubstrat ist aus der WO 2010/051976 A1 der Anmelderin bekannt. Mit dieser Druckschrift wird erstmals offenbart, dass für optoelektronische Vorrichtungen wie etwa Solarzellen, Leuchtvorrichtungen o.dgl., transparente Elektrodenflächen, wie sie etwa In traditionell bekannter Weise durch elektrisch leitende Oxidschichten (TCO = transparent conductive oxides, transparente leitende Oxide) realisiert wurden, in vorteilhafter Weise durch ein einfach herstellbares, reproduzierbare Eigenschaften und eine günstige elektrische Leitfähigkeit aufweisende Gewebeflächen ersetzt werden könnte. Insbesondere bot sich beim als gattungsbildend herangezogenen Stand der Technik die flexible Möglichkeit mittels eines Gewebes aus elektrisch leitenden und nicht-leitenden Fasern jeweils gewünschte elektrische Leiteigenschaften einzustellen, die Möglichkeit, unerwünschte, widerstandsbedingte Spannungsabfälle wie sie etwa bei großflächigen TCO-Elementen auftraten (wie etwa beim Einsatz von ITO) zu vermeiden, dabei zusätzlich und vorteilhaft die flexiblen Eigenschaften eines Gewebes zu nutzen, wogegen etwa typischerweise sprödes TCO-Material die Einsatzmöglichkeiten traditionell beschränkt hat.

Allerdings hat sich im Zuge weiterer Entwicklungen gewebebasierter Elektrodensubstrate für optoelektronische Vorrichtungen herausgestellt, dass gerade eine aus der WO 2010/051976 bekannte Substratstruktur, bedingt durch die Kombination aus Gewebe und das Gewebe (teilweise) durchtränkender, selbst nicht-leitender Polymerbeschichtung, eine vergleichsweise hohe Oberflächenrauhigkeit aufweist, welche sich gerade für organische optoelektronische Vorrichtungen (wie etwa organische Solarzellen) als nachteilig herausgestellt haben; so wirken sich etwa (Oberflächen-Rauhheitsbedingte) Inhomogenitäten nachteilig für die jeweils gewünschten optischelektronischen Eigenschaften aus.

Zum weiteren Stand der Technik wird verwiesen auf die US 2009/166877 A1, weiche die Herstellung von Elektroden aus verwebten leitenden Fasern sowie das Aufbringen von Leiterstrukturen darauf offenbart.

Aufgabe der vorliegenden Erfindung ist es daher, eine gattungsbildende Vorrichtung in Form eines Gewebesubstrats für eine optoelektronische Vorrichtung im Hinblick auf ihre Eignung für organische optoelektronische Anwendungen zu verbessern, dabei insbesondere eine (elektrisch und/oder mechanisch wirksame) Oberflächenrauhheit zu vermindern und damit die Grundlage für eine größere Gleichmäßigkeit und Homogenität einer mittels eines solchen Substrats erreichten Leiterschicht als Elektrode zu schaffen. Ferner ist ein Herstellungsverfahren für ein solches Gewebesubstrat für eine optoelektronische Vorrichtung zu schaffen.

Die Aufgabe wird durch das Elektrodensubstrat mit den Merkmalen des Hauptanspruchs, die flächige optoelektronische Vorrichtung nach dem unabhängigen Patentanspruch 6 sowie das Verfahren zum Herstellen eines Elektrodensubstrats nach dem unabhängigen Patentanspruch 7 gelöst; vorteilhafte Weiterbildungen der Erfindung sind in den Unteransprüchen beschrieben.

In erfindungsgemäß vorteilhafter Weise wirkt dabei das Gewebe, genauer gesagt die im Gewebe vorgesehenen elektrisch leitenden Fasern, unter Abkehr der in der WO 2010/051976 vermittelten Lehre, vollständig etwa auf transparente und leitende Oxidschichten zu verzichten, oberflärhenseitig zusammen mit einer zusätzlichen Leitbeschichtung, welche gleichwohl, und insoweit den Grundgedanken der WO 2010/051976 aufgreifenden, elektrisch leitend mit den aus der polymeren Beschichtung herausragenden bzw. freigelegten und/oder freiliegenden planen Abschnitt der elektrisch leitenden Fasern zusammenwirken kann.

Dabei sorgt die vorliegende Erfindung erfindungsgemäß vorteilhaft dafür, dass wiederum durch geeignete Auswahl und Ausgestaltung der nicht-leitenden Fasern (auch in der Gewebestruktur und Gewebebindung, relativ zu den nicht-leitenden Fasern), die jeweils gewünschten mechanischen Eigenschaften (z.B. Flexibilität) eingestellt und kombiniert werden können mit den gewünschten elektrischen Eigenschaften (also z.B. Flächenwiderstands- bzw. Leitfähigkeitseigenschaften) und gewünschten optischen Eigenschaften (also etwa Transmissivität für Licht, bestimmt durch die offene Fläche zwischen dem Gewebe bzw, eine jeweilige Gewebedichte die Transparenz der Fäden und die Lichtstreuung der Fädenoberfläche). Erfindungsgemäß vorteilhaft wird nunmehr eine solche Struktur kombiniert mit einer elektrisch kontaktierenden und aufliegenden Leitbeschichtung, welche, da auf die Vielzahl der hervorstehenden (aus der Beschichtung herausragenden) Abschnitte der leitenden Fasern elektrisch zugreifend, eine flächige Durchkontaktierung ermöglicht, wobei das unterliegende, elektrisch leitende Gewebe in vorteilhafter Weise etwa den elektrischen Flächenwiderstand einer reinen TCO- (bzw. auch alternativ leitenden Poymer-)Schicht herabsetzt und so zu einem vorteilhaften Ergebnis führt, dass einerseits, durch die aufgebrachte Leitbeschichtung, besonders glatte, sehr niedrige Rauheitswerte aufweisende Oberflächen erzielbar sind, welche sich wiederum für das Aufbauen (bzw. Realisieren) von organischen optoelektronischen Bauelementen bzw. Baugruppen äußerst gut eignen, andererseits die unterliegende, metallisch durchwirkte und damit hohe Leitfähigkeiten aufweisende Gewebestruktur kontaktierend dafür sorgt, dass selbst große Flächen (auf bzw. entlang der Leitbeschichtung) keinen signifikanten Spannungsabfall erfahren, insoweit, in der vorbeschriebenen Weise, mechanische, elektrisch-/elektronische sowie optische Eigenschaften miteinander optimiert sind.

Dabei ermöglicht es die vorliegende Erfindung zusätzlich vorteilhaft, dass eine lediglich sehr dünne Leitbeschichtung aufgebracht werden muss (da es ja auf elektrische Leitfähigkeit bzw. mögliche Spannungsabfälle entlang des eigentlichen Leitbeschichtungsmaterials selbst nicht mehr ankommt), mit der positiven Konsequenz, dass (vergleichsweise teueres) Material für die Leitbeschichtung, etwa bei der Verwendung von transparenten, elektrisch leitenden Polymeren, TCO, Kohlenstoff-Nanoröhrchen oder Metall-Nanopartikel sehr materialsparend eingesetzt werden kann.

Damit schafft die vorliegende Erfindung erstmals die Möglichkeit, vorteilhafte Leitfähigkeits-, Flexibilitäts- und optische Eigenschaften von gewebebasierten Elektroden mit den besonders günstigen (da wenig rauhen) Oberflacheneigenschaften von ansonsten bekannten elektrisch leitenden Polymer- und/oder TCO-Schichten zu kombinieren, so dass gerade für das zunehmend bedeutsame Gebiet der organischen optoelektronischen Vorrichtungen günstige Bedingungen zur Herstellung der hierfür verwendeten Elektroden geschaffen werden.

Während es im Rahmen der vorliegenden Erfindung bevorzugt ist, die Leitbeschichtung in ihrer Dicke so einzurichten, dass diese (bezogen auf den getrockneten bzw. ausgehärteten Zustand der jeweils aufgetragenen Beschichtungen) maximal die Dicke erreicht, die maximal einem Zehntel (1/10) des Durchmessers der verwendeten elektrisch leitenden bzw. elektrisch nicht-leitenden Fasern entspricht, so wird in der Praxis eine wesentlich dünnere Leitbeschichtung aufzutragen sein, die in bevorzugten Weiterbildungen weniger als 1/10 des durchschnittlichen bzw. mittleren Faserdurchmessers, weiter bevorzugt weniger als 1/100 oder gar weniger als 1/200 dieses Faserdurchmessers beträgt und somit eindrucksvoll klarstellt, dass die vorliegende Erfindung das transparente, leitende Material für die Leitbeschichtung zwar verwendet, jedoch diese Schicht so dünn wie möglich hält (mit zusätzlichen vorteilhaften Wirkungen, dass etwa eine typischerweise spröde Oxidschicht realisiert etwa mittels ITO als TCO) mit Abnehmen der Schichtdicke zunehmend flexibler und weniger spröde wird und so selbst bei mechanischer Beanspruchung deutlich weniger zum Brechen neigt.

Vor dem Hintergrund, dass bevorzugte Realisierungsformen der Erfindung einen typischen Durchmesser der elektrisch leitenden Fasern im Bereich zwischen ca. 20µm und 200µm, bevorzugt zwischen 30µm und 80µm, ansiedeln (wobei 60µm ein in der Praxis günstiger Wert für den Fäserdurchmesser einer leitenden Faser ist), bedeutet dies, dass eine Schichtdicke der Leitbeschichtung (im trockenen Zustand) im Regelfall kleiner als 2µm beträgt, wobei typische Trockenschichtdicken eines als Leitbeschichtung aufgetragenen TCO oder einer leitenden Polymerschicht (etwa PEDOT: PSS) im Bereich zwischen 0,01µm und 10µm liegen, wiederum ein hier bevorzugter Bereich zwischen 0,02µm und 1µm.

Ein resultierender Oberflächenwiderstand der Elektrode wird dann von den verschiedenen Leitfähigkeiten sowohl der leitenden Fasern, einer Dichte dieser leitenden Fasern im Gewebe, ferner einer effektiven Ausgestaltung der aus der Beschichtung hervorstehenden (bzw. freigelegten) Abschnitte der leitenden Fasern sowie letztendlich einem für die elektrisch leitenden Fasern verwendeten Material bestimmt, zusätzlich dann von dem Material bzw. einer Schichtdicke der Leitbeschichtung. Dabei werden die elektrisch leitenden Fasern typischerweise so ausgewählt, dass diese elektrische Widerstandseigenschaften im Bereich zwischen 1Ω/m und 1000Ω/m, dabei bevorzugt zwischen 1Ω/m und 10Ω/m aufweisen, wobei etwa eine als Draht realisierte AgCu-Faser eine Dicke von 60µm einen Widerstand von 6Ω/m zeigt.

Für die elektrisch leitenden Fasern kommen als Materialien dabei sowohl reine Metalle (also etwa Ag, Cu, Mo, W, Al, Au, HTW, XHTW, SS o.dgl.) in Frage, als auch Metalllegierungen (AgCu, CuSn6, CuNi, CuNiMn, CuZn, AIMg5 usw.), ferner metall-plattierte Drähte (CCA, HTCCA, Ms/Ag, Cu/Ag, Cu/Ni usw.), oder aber metallisierte Polymerfasern, wie beispielsweise versilberte Nylongarne, oder etwa mit AgCu oder CuSn5 metallisierte Polymergewebe.

Die elektrisch nicht-leitenden Fasern zur Realisierung der Erfindung , auch wiederum bevorzugt im Bereich zwischen 20µm und 200µm Faserdicke, mit einer weiter bevorzugten Faserdicke im Bereich zwischen 30µm und 70µm, weisen bevorzugt als Mono- oder Multifilamente realisierte PEN, PBT, PA, Glas, PTFE, PI, PE, PP oder vergleichbare Polymere bzw. Werkstoffe auf, wobei ein besonders günstiger Werkstoff ein transparentes PET als Monofilament ist.

In bevorzugter Realisierung der vorliegenden Erfindung werden die elektrisch nicht-leitenden und die elektrisch leitenden Fasern zu einem Gewebe verwoben, welches eine offene Fläche (d.h. einen Anteil von in der Projektion nicht von Fasern belegter Fläche) im Bereich zwischen 70% und 90% aufweist, wobei in bevorzugter Weise das Gewebe so ausgestaltet ist, dass es eine offene Fläche im Bereich zwischen 40% und 80% besitzt.

Die vorliegende Erfindung ermöglicht es in besonders günstiger Weise, durch Modifikation der Art des Gewebes (z.B. der Gewebebindung), die jeweils gewünschten Eigertschaften durch Ausgestaltung des Faserverlaufs der elektrisch leitenden Fasern relativ zu den elektrisch nicht-leitenden Fasern vorzugeben. So ist es im Rahmen der Erfindung günstig, die elektrisch leitenden Fasern des Gewebes nur in einer oder beiden Geweberichtungen (d.h. Kett- oder Schussrichtung) vorzusehen, wobei die Schussrichtung hier wiederum bevorzugt ist.

In der praktischen Realisierung der Erfindung bei typischen Drahtdurchmessem der elektrisch leitenden Fasern im Bereich zwischen 30µm und 80µm, hat sich ein Abstand benachbarter, paralleler, elektrisch leitender Fasern im Gewebe zwischen 0,2mm und 200mm als günstig erwiesen, wobei weiter bevorzugt ein Abstand zwischen 0,5mm und 2mm ist. Je nach Ausgestaltung des Gewebes führt dies dazu, dass zwischen ca. 2 und 600 benachbarte, nicht-leitende Fasern dann zwischen jeweils benachbarten leitenden Fasern verlaufen.

Im Rahmen der Erfindung liegt es ferner, die Bindung des Gewebes so auszugestalten. dass die aus der Beschichtung hervorstehenden Abschnitte (insoweit querschnittliche Scheitel der leitenden Fasern) möglichst groß sind und/oder möglichst günstige Kontakteigenschaften für die zusammenwirkende Leitbeschichtung aufweisen. So ist es zwar von der Erfindung umfasst, prinzipiell sämtliche Grundbindungsarten (etwa Leinwand- Atlas- und Körperbindung) für das Gewebe vorzusehen, bevorzugt ist es jedoch, die nicht-leitenden Fasern etwa in Form einer klassischen Leinwandbindung 1/1 vorzusehen und/oder die leitenden Fasern in einer Körperbindung anzuordnen. Die elektrisch leitenden Fasern übergreifen gemäß der Erfindung eine Mehrzahl von orthogonal bzw. quer verlaufenden nicht-leitenden Fasern, wobei hier, etwa bei typischen und günstig geeigneten Körperbindungen 5/1, 4/2, 3/3, zwischen 2 und 5 querverlaufende Fasern übergriffen werden.

Eine Variante der Erfindung, welche gleichwohl auch mit den vorstehenden Realisierungsformen der Erfindung kombinierbar ist, sieht vor, dass zumindest ein Teil der elektrisch leitenden Fasern (z. B: in einem einfach gewobenen 1/1-Leinwandgewebe) gerade verläuft und so mit dem Gewebe zusammenhängt (und insoweit querschnittlich keiner Wellen- bzw. Bogenform folgt), dass sie sich lang gestreckt und horizontal entlang der Gewebeoberfläche (und insoweit dann auch entlang der Substratoberfläche) erstreckt, sodass der erfindungsgemäß aus der Beschichtung hervorstehende bzw. freigelegte) Abschnitt ein Bereich der Faser ist, welcher durch Materialabtrag einen planen (z. B. streifenförmigen) Oberflächenabschnitt ausbildet. Eine derartige Faser, lang gestreckt und an einem Abschnitt hervorstehend, bietet damit den offensichtlichen Vorteil einer großen potentiell kontaktbildenden Übergangsfläche zu einer aufliegenden Leitschicht, wobei es diese Variante der Erfindung zusätzlich und weiterbildungsgemaß vorteilhaft vorsieht, einen solchen hervorstehenden Faserabschnitt durch Schleifen oder Polieren abzutragen, bevorzugt auf ein Oberflächenniveau mit der benachbarten transparenten und nicht leitenden Beschichtung zu nivellieren und so die Möglichkeit zu bieten, dass eine vollständig plane Oberfläche erzeugt wird, welche lediglich von (bevorzugt wiederum in regelmäßigen Abständen zueinander parallel verlaufenden) freiliegenden und leitenden Streifen durchzogen wird, weiche die freigelegten und nivellierten lang gestreckten Abschnitte der elektrisch leitenden Fasern sind. Während es für diese Variante der Erfindung bevorzugt ist, auf die so vorbereitete, bevorzugt durchgehend plane Oberfläche (ein- oder zweiseitig bezogen auf das Gewebe) eine (wiederum gemäß der vorstehend beschriebenen Erfindung dünne) Leitschicht aufzubringen, ist es gleichwohl denkbar, auch, etwa in der Art eines Zwischen- bzw. Vorprodukts, lediglich ein entsprechend präpariertes Gewebe zu bereiten.

In Realisierung der Erfindung ist die Beschichtung, ein das Gewebe im Wesentlichen tränkendes und nicht-leitendes Polymer, welches das Hervorsteshen von peripheren Abschnitten der leitenden Fasern ermöglicht und, mittels eines transparenten Polymermaterials realisiert, etwa aufweisend ein Epoxidharz bzw. einen Epoxidlack, auch geeignet (jeweils transparent) UV-härtende Lacke, Lösemittellacke, wässrige Lacke, Emulsionen, Polyimide sogenanntes Hotmelt o.dgl..

Im Rahmen der Erfindung, welche sich insbesondere für eine Ausbildung der Elektrode eignet, welche lediglich auf einer flächigen Seite die Leitbeschichtung aufweist, wird die Beschichtung in der Art einer Indirekt-Beschichtung mittels einer vorgesehenen (und typischerweise wiederum transparenten) Polymerfolie aufgetragen, dergestalt, dass das polymere Beschichtungsmaterial auf diese Folie aufgetragen ist, anschließend durch Zusammenführen dieser mit dem Beschichtungsmaterial versehenen Folie und dem Gewebe eine Nasskaschierung erfolgt und dann entweder die Folie auf der Anordnung verbleibt (was etwa Im Hinblick auf Stabilität, Barriereeigenschaften oder o.dgl., insbesondere für OLEDs oder OSCs vorteilhaft sein kann), alternativ dann die Folie entfernt wird. Auch sind im Rahmen alternativer Realisierungsformen der Erfindung andere Möglichkeiten des Einbringens der Beschichtung auf/in das Gewebe möglich, etwa durch Direktbeschichtung, Einlaminieren o.dgl.. Für diese Trägerfolie, welche bevorzugt wiederum eine typische Dicke im Bereich zwischen 20µm und 200µm (weiter bevorzugt zwischen 50µm und 100µm) aufweist, eignen sich verschiedene transparente Werkstoffe, etwa PET, PEN, PBT, PI, PA12, PA11, PA6, PA6.6, PTFE, PE, PP o.dgl., wobei PET sowie PEN als Folienmaterial bevorzugt sind.

Im Ergebnis entsteht durch die vorliegende Erfindung ein hochgradig flexibles, dabei mechanisch, elektrotechnisch und optisch leistungsfähiges Substratsystem, welches die Vorteile traditioneller leitender Oxidschichten (TCO etwa realisiert durch ITO, FTO, AZO, ATO o.dgl.), ergänzend oder alternativ traditioneller transparenter und elektrisch leitender Polymere (wie etwa PEDOT:PSS, Kohlenstoff-Manoröhrchen oder Metall-Nanopartikel) kombiniert mit den günstigen Hersteilungs-, Flexibilitäts- und elektrischen Leitungseigenschaften von mit leitenden Fasern versehenen Geweben und so zu einer Kombination gelangt, welches Ideale Oberflächeneigenschaften (besonders niedrige Rauheitswerte) für etwa eine Realisierung organischer optoelektronischer Bauelemente anbietet, dabei gleichwohl den Einsatz (Materialaufwand) für die obersten leitenden Schichten zur Realisierung der Leitbeschichtung durch die Möglichkeit, diese sehr dünn aufzubringen, minimiert. Dabei eignet sich die vorliegende Erfindung, wie dargelegt, in besonders günstiger Weise zur Realisierung optoelektronischer organischer Vorrichtungen, etwa flächiger, flexibler Dünnschichtsolarzellen (OSC, DSC, µc-Si:H, aSi:H oder andere) oder aber flexibler Tandemzellen, ist jedoch nicht auf diese Anwendungsgebiete beschränkt, vielmehr eignet sich die vorliegende Erfindung auch zur Realisierung weiterer Elektroden, bei welchen günstige und homogene, elektrische und mechanische Eigenschaften mit Flexibilität, niedriger Rauheit und hoher Transparenz kombiniert werden müssen.

Weitere Vorteile, Merkmale und Einzelheiten der Erfindung ergeben sich aus der nach-folgenden Beschreibung bevorzugter Ausführungsbeispiele sowie anhand der Zeichnungen; diese zeigen in
- Fig. 1: eine schematische Schnittansicht durch den Aufbau eines Elektrodensubstrats für eine organische optoelektronische Vorrichtung gemäß einer ersten bevorzugten Ausführungsform der Erfindung (allerdings gezeigt ohne Leitschicht);
- Fig. 2: eine Variante zur Gewebekonfiguration in der Fig. 1 als Zwischenstufe zur Realisierung eines Elektrodensubstrats mit einer alternativen Gewebebindung als 3/3 Köperbindung;
- Fig. 3: eine dreidimensionale Ansicht der Gewebe- und Beschichtungsanordnung gemäß Fig. 2;
- Fig. 4: eine Schnittansicht durch eine Anordnung gemäß Fig. 2, Fig. 3 zum Realisieren eines nicht von der Erfindung umfassten Tandernsubstrats, welches beidseitig eine Leitbeschichtung aufweist;
- Fig. 5, Fig. 6: zwei Perspektivansichten beispielhaften Elektrodensubstrats, wonach zueinander entlang einer Richtung parallel verlaufende elektrisch leitende Fasern sich langgestreckt entlang der Substratoberfläche erstrecken und, insbesondere durch Schleifen und/oder Polieren, zum Herstellen einer durchgehend planen, nivellierten Substratoberfläche abgetragen sind (Figur 5), wobei dann, Figur 6, auf diese plane Oberfläche eine dünne Leitschicht aufgebracht ist und
- Fig. 7, Fig. 8: ein weiteres Beispiel der Variante gemäß Figur 5, Figur 6, wonach die nivellierte, mit durchgängigen freigelegten Abschnitten der leitenden Fasern versehene Oberfläche durch beidseitigen Materialabtrag vom beschichteten Substrat realisiert ist (Figur 7), mit zusätzlicher Leitbeschichtung (Figur 8).

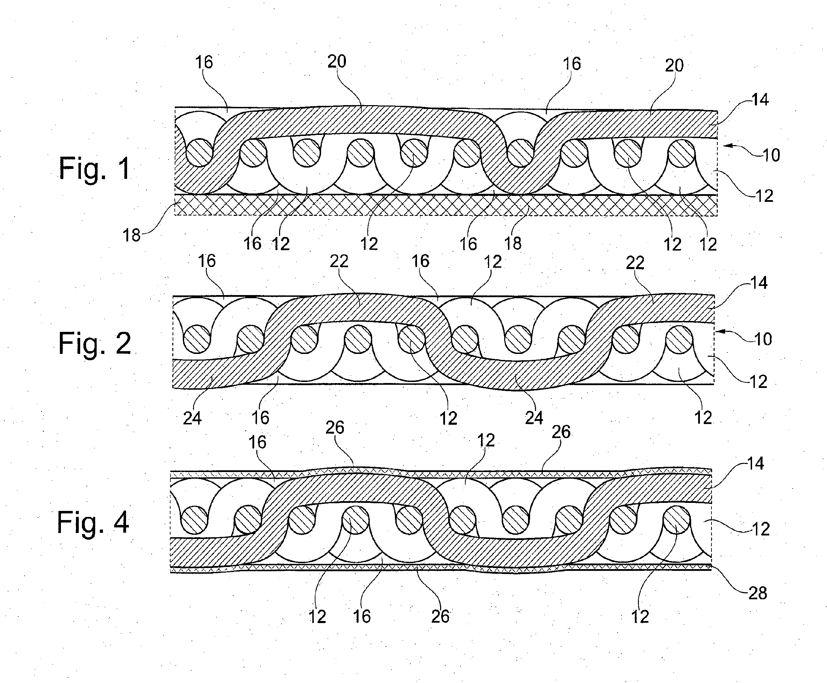

Die Fig. 1 zeigt eine schematische Schnittansicht durch den Aufbau eines Elektronensubstrats für eine organische Solarzelle gemäß einer ersten bevorzugten Ausführungsform. Ein in der Fig. 1 in der Schnittansicht gezeigtes Gewebe 10 ist realisiert aus PET-Fäden 12 einer Dicke von 60 µm (genauer: transparenten PET-Fäden), mit welchen, in der Art einer 5/1-Körperbindung, metallische Fasern 14 (Drähte), bestehend aus einer CuAg-Legierung und einer Dicke von 60 µm verwoben sind, wobei sich die Metalldrähte 14, jeweils zueinander parallel und um einen Abstand von ca. 1 mm beabstandet, lediglich in der Schussrichtung erstrecken und, wie in der Schnittansicht der Fig. 1 gezeigt, entsprechend der 5/1-Körperbindung fünf quer verlaufende der nicht leitenden Fasern 12 übergreifen.

Diese Gewebestruktur ist beschichtet (ausgefüllt bzw. durchtränkt) mit einer Harzschicht (Beschichtung) 16, welche ein UV-härtendes Epoxidharz aufweist und im dargestellten Ausführungsbeispiel in der Art einer Indirekt-Beschichtung mittels einer transparenten PET-Folie 18 einer Dicke von 50µm aufgebracht wurde. Genauer gesagt wurde das in der vorstehend beschriebenen Weise strukturierte Gewebe in Verbindung gebracht mit der Folie 18, auf welcher, im flüssigen bzw. pastösem Zustand, das Harzmaterial für die Beschichtung 16 aufgebracht war. Durch Zusammenbringen erfolgte dann die Durchtränkung dergestalt, dass nach Aushärten des Harzmaterials die Beschichtung 16 das Gewebe 12, 14 praktisch vollständig umschließt, lediglich jedoch obere Abschnitte 20 der Drähte 14 aus dem Harzmaterial der Beschichtung 16 herausragen und dort kontaktierbar sind.

Im fertig gestellten Ausführungsbeispiel der Fig. 1 würde die Folie 18 in der dargestellten Position verbleiben (und so für eine zusätzliche mechanische Stabilisierung bzw. Barrierewirkung sorgen), darüber hinaus würde, auf die Beschichtung 16 bzw. die freiliegenden metallischen Abschnitte 20 der Drähte 14 eine dünne Schicht aus elektrisch leitendem und transparentem Polymer derart aufgebracht, dass diese zusätzliche Leitschicht (in der Fig. 1 nicht gezeigt) eine Dicke von ca. 200 nm aufweist. Geeignetes Material für eine solche Leitschicht ist z.B. PEDOT: PSS, wie es etwa von der Firma Agfa unter der Bezeichnung "HWS 5" oder aber von der Firma Heraeus unter der Bezeichnung "Clevios P VP CH 8000" angeboten wird; aufgebracht werden würde dieses Material mit einem gängigen Beschichtungsverfahren, wie etwa Reverse-Roll, einer Vorhangbeschichtung, einer Schlitzdüse, mittels Siebdruck od.dgl., wobei sich sowohl kontinuierliche Auftragsverfahren (etwa Rolle-zu-Rolle), als auch diskontinuierliche Verfahren (Siebdruck oder Spin-Coating) eignen.

Mit der so hergestellten Elektrode ist dann die Basis für die darauf aufzubauenden aktiven bzw. weiteren Schichten einer organischen Solarzelle (nicht gezeigt) geschaffen.

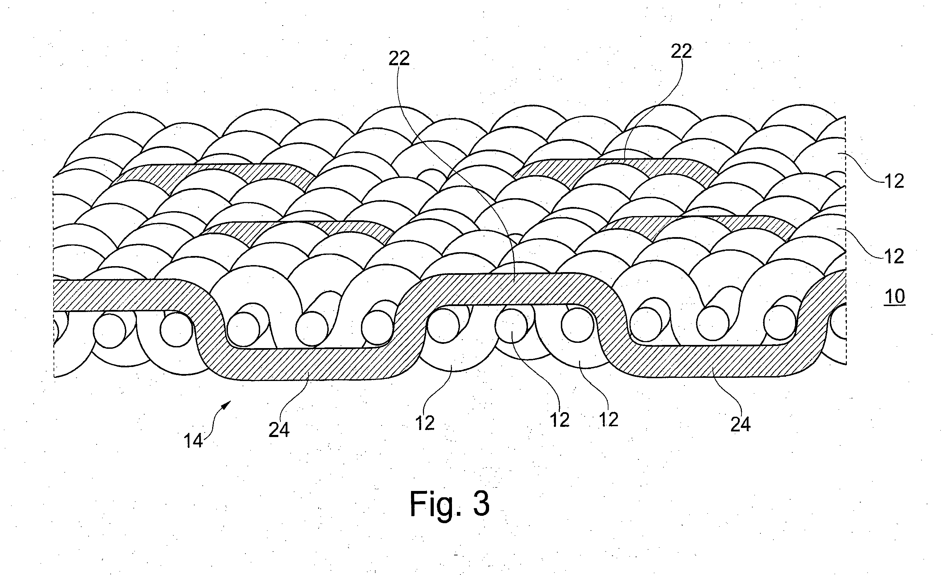

Die Fig. 2 und 3 verdeutlichen eine Ausführungsform, welche nicht von der Erfindung erfasst wird. Dabei entsprechen die in diesen Figuren verwendeten Bezugszeichen denen des ersten Ausführungsbeispiels der Fig. 1 und werden für identische bzw. äquivalente Funktionselemente verwendet: Wiederum erstreckt sich in Schussrichtung ein CuAg-Draht 14 der Dicke 60µm, hier allerdings in der Art einer 3/3-Körperbindung, wobei die nichtleitenden Fasern 12 wiederum, wie im ersten Ausführungsbeispiel, transparente PET-Fäden einer Dicke von 20 bis 60µm sind. Auch hier durchtränkt die Beschichtung 16 das so gebildete Gewebe, allerdings dergestalt, dass nicht nur, wie beim ersten Ausführungsbeispiel der Fig. 1, lediglich auf einer Flachseite in Form der freiliegenden Abschnitte 20 eine elektrische Kontaktierbarkeit der Drähte 14 gegeben ist, sondern im Ausführungsbeispiel der Fig. 2 bis 4 beidseits, in Form der jeweils oben liegenden leitenden Abschnitte 22, 24.

Entsprechend bietet sich damit die Möglichkeit, beidseitig, also zum Kontaktieren der Abschnitte 22 sowie 24, jeweils eine elektrisch leitende und transparente Polymerschicht (PEDOT: PSS, wie im ersten Ausführungsbeispiel der Fig. 1) als Leitschicht aufzubringen. Diese in Fig. 4 gezeigte Schicht 26 (im Hinblick auf die Abschnitte 22) bzw. 28 (im Hinblick auf die Abschnitte 24) ermöglichen somit eine Elektrodenkonfiguration, welche beidseitig die vorteilhaften elektrischen, optischen und mechanischen Eigenschaften der Verbindung von Gewebe mit außenliegenden leitenden Schichten verbindet, bei optimierter Rauheit (wie auch im ersten Ausführungsbeispiel) im Hinblick dann auf eine wirksame Außenfläche der jeweiligen Schichten 26, 28 zum Aufbauen der weiteren Schichten für ein jeweiliges optoelektronisches Erzeugnis, etwa sogenannte Tandemzellen.

Die Fig. 3 zeigt In der Perspektivansicht und analog zur Fig. 2, wie die einzelnen Gewebefasern relativ zueinander verlaufen; deutlich erkennbar ist, wie der Draht 14 lediglich in der Schussrichtung verläuft, die 3/3-Körperbindung ausbildet und, im Hinblick auf benachbarte parallele Drahtverläufe, versetzt angeordnet ist.

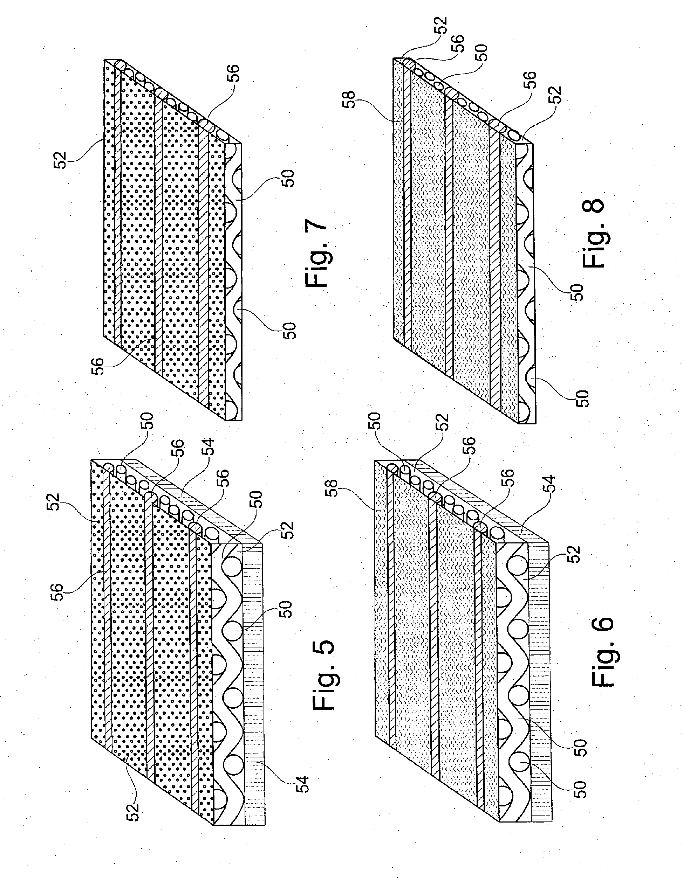

Anhand der Figuren 5 bis 8 wird nachstehend eine Variante der Erfindung beschrieben, welche den Erfindungsgedanken der aus der Beschichtung hervorstehenden leitenden Faserabschnitte erweitert in streifenförmige, leitende Abschnitte, welche sich i. W. vollständig entlang zumindest einer Dimension des Gewebes auf bzw. an dessen Oberfläche erstrecken und so den metallischen Gewebekontakt etwa für eine aufliegende Leitbeschichtung weiter verbessern.

So zeigt die Figur 5 ein Beispiel bei welchem ein einfaches Gewebe mit 1/1 Leinwandbindung 50 aus nicht leitenden Fasern, genauer: ein Gewebe aus PEN-Garn, (Faserdurchmesser 35 µm transparent) beschichtet ist mit transparentem UV-härtendem Lack 52. Einseitig ist diese Beschichtung versehen mit einer PET-Folie 54 ei-ner Dicke von 75 µm, entsprechend einigen der vorbeschriebenen Ausführungsbeispiele.

Gemäß der vorliegenden Variante der Figur 5 erstrecken sich jedoch nunmehr mehrere leitende Fasern 56 (aus Molybdän-Draht, Drahtdurchmesser 40 µm) langgestreckt, zueinander parallel so entlang des Gewebes und der Folie 54 gegenüber liegenden Substratoberfläche, dass nach einem Schleifen der Substratoberfläche die in Figur 5 gezeigte nivellierte, durchgehend plane Oberflächenstruktur entsteht, nämlich eine Mehrzahl von parallel zueinander verlaufenden streifenförmigen Leiterabschnitten, welche jeweils plane Oberflächen ausbilden und durch Materialabtrag der Fasern 56 gebildet sind, jeweils beidseits begrenzt von Oberflächenabschnitten der Lackbeschichtung 52.

Wird die leitende Faser 56 so auf bzw. in das Gewebe 50 gebracht (bzw. in der gezeigten Form eingewoben), das sie horizontal und absolut gerade (d. h. ohne Wellen-, Sinus- oder querschnittliche Krümmungsform) verläuft, entsteht nach dem Beschichten und einem anschließenden Schleifen und bevorzugt zusätzlichem Polieren eine durchgehend leitende Bahn über die gesamte Folienfläche. Dabei ist die Breite dieser Bahn ("BUS-BAR") abhängig vom Durchmesser der leitenden Faser sowie eine Abtragtiefe des Schleifvorgangs, sodass eine Streifenbreite bis zum maximal dem Faserdurchmesser erreichbar ist.

In der Praxis würde der in Figur 5 gezeigte Verbund einseitig abgetragen (alternativ, wie in der Figur 7 gezeigt, ein beidseitiges Abtragen erfolgen), wobei geeignete Scher-, Schleif- bzw. Poliermaschinen herangezogen werden, sodass eine möglichst glatte Oberfläche entsteht. Durch Schneiden oder Walzen-, Schmirgel- und andere Schleifverfahren und bei geeigneter Einstellung des Schleifmittels (sowie weiterer Parameter, wie etwa einer Rotiergeschwindigkeit und Rotierrichtung von Walzen oder Schleifbändern) lässt sich so eine sehr glatte Oberfläche erzielen; typische Ergebnisse, wie sie auf der Basis der Schemadarstellungen der Figuren 5 bis 8 gezeigt sind, setzen Schleifscheiben einer Körnung zwischen 1000 und 1200 ein bzw. eine Diamantpolitur im Bereich zwischen 1 µm und 3 µm. Ergänzend wird, in geeigneten Abständen, das Substrat gereinigt.

Insbesondere diese Vorgehensweise des Materialabtrags (erst wird Fasermaterial 50, welche die leitenden Fasern kreuzen, abgetragen. Dann werden nicht leitende Fasern mit benachbartem [ausgehärtetem] Lackmaterial der Beschichtung 52, wie auch Teile der leitenden Fasern abgetragen) ermöglicht es damit je nach Ausgestaltung dieses Verfahrensschritts, eine hochgradig plane, ebene und damit kontaktgünstige Oberfläche zu schaffen; optimiert wird damit, wie in der Weiterbildung der Figur 6 gezeigt, das Aufbringen und Kontaktieren einer Leitbeschichtung 58, im Ausführungsbeispiel realisiert als PEDOT: PSS einer Schichtdicke von 200 nm (im ausgehärteten bzw. getrockneten Zustand).

In der konkreten Realisierung und mit den wie vorbeschrieben verwendeten Parametern bzw. Substanzen lassen sich somit Oberflächenrauhigkeiten im Nanometerbereich (bis typischerweise <500 nm) erreichen, sodass die in Figur 5 (und auch in der Weiterbildung der Figur 7) gezeigte geschliffene bzw. polierte Oberfläche die Oberflächenqualität von Kunststoff- bzw. Metallfolie erhält. Damit ist dann, insbesondere in der praktischen Anwendung für optoelektronische Anwendungen mit besonders dünnen leitenden Schichten, die Gefahr von Kurzschlüssen erheblich herabgesetzt, sodass insbesondere für die bevorzugten Anwendungsfälle als OLED, OPV, dünnschichtige Solarzellen oder dergleichen, besonders gute Eignung besteht, gleichwohl die vorliegende Erfindung nicht auf diese Anwendungsbeispiele beschränkt ist.

Evident ist zudem die erhöhte Kontaktfläche, der freigelegten Streifenform etwa der Figur 5, gegenüber den vorbeschriebenen Ausführungsbeispielen der Erfindung.

Nicht zuletzt sind durch diese weiter verbesserten Oberflächeneigenschaften weitere Verarbeitungsschritte, wie etwa ein nachfolgendes mögliches Laminieren, Beschichten mit anderen Beschichtungen oder dergleichen, generell vereinfacht, ebenso wie eine allgemeinte Homogenität in einer so gebildeten Mehrschichtanordnung.

Die vorliegende Erfindung ist nicht auf die gezeigten Ausführungsbeispiele beschränkt, vielmehr bietet es sich an, den Erfindungsgegenstand für jegliche Anwendungen zu verwenden, bei welchen transparente und flächige Elektroden einzusetzen sind, die im Hinblick auf ihre wirksamen Oberflächen geglättet werden sollen (nämlich mit transparenten Leitflächen zusammenwirken), ohne dass besondere Eigenschaften dieser Leitflächen, etwa Sprödigkeit, die flexiblen und optischen Eigenschaften der Vorrichtung nachteilig beeinflussen.

## Patentansprüche

1. Elektrodensubstrat für eine optoelektronische Vorrichtung mit einem elektrisch leitende (14; 56) sowie nicht-leitende (12; 50) und transparente Fasern aufweisenden Gewebe (10)
und einer aus einem transparenten, elektrisch nicht-leitenden Polymermaterial realisierten Beschichtung (16; 52), **dadurch gekennzeichnet, dass**
die Beschichtung mit einer transparenten und elektrisch leitenden Leitbeschichtung (26, 28, 58) großflächig so versehen ist, dass die hervorstehenden bzw. freigelegten Abschnitte zum Herstellen elektrischer Kontakte mit der Leitbeschichtung zusammenwirken, insbesondere in die Leitbeschichtung eingreifen und/oder hineinragen und/oder eine plane Kontaktfläche für die Leitbeschichtung ausbilden wobei die Leitbeschichtung eine Schichtdicke aufweist, die kleiner ist als ein Durchmesser, insbesondere ein mittlerer Durchmesser, der elektrisch leitenden und elektrisch nicht-leitenden Fasern des Gewebes,
die elektrisch leitenden Fasern im Gewebe in nur einer der Geweberichtungen, bevorzugt in der Schussrichtung, verlaufen
und eine Gewebebindung der elektrisch leitenden Fasern des Gewebes so eingerichtet ist, dass zum Realisieren der hervorstehenden Abschnitte die Fasern, insbesondere in der Art einer Körperbindung, mindestens 2, bevorzugt zwischen 3 und 6, quer verlaufende der nicht-leitenden Fasern übergreifen,
das Gewebe in die Beschichtung so eingebettet ist, dass zumindest auf einer Seite der Beschichtung Abschnitte (20; 22; 56) der leitenden Fasern aus dem nicht-leitenden Polymermaterial der Beschichtung hervorstehen und/oder freigelegt sind,
und die Beschichtung auf einer polymeren, elektrisch nicht-leitenden und transparenten Trägerfolie aufgebracht ist, welche, bezogen auf das Gewebe, der einseitig aufgebrachten Leitbeschichtung gegenüberliegt.

2. Substrat nach Anspruch 1, **dadurch gekennzeichnet, dass** das Verhältnis der Schichtdicke der Leitbeschichtung bezogen auf den Durchmesser der Fasern kleiner als 1:10, bevorzugt kleiner als 1:100, ist.

3. Substrat nach Anspruch 1 oder 2, **dadurch gekennzeichnet, dass** die elektrisch leitenden Fasern und/oder die elektrisch nicht-leitenden Fasern einen Durchmesser im Bereich zwischen 10µm und 200µm, insbesondere zwischen 20µm und 80µm, aufweisen.

4. Substrat nach einem der Ansprüche 1 bis 3, **dadurch gekennzeichnet, dass** die Leitbeschichtung ein transparentes Polymer und/oder ein transparentes Oxid, Kohlenstoff-Nanoröhrchen oder Metall-Nanopartikel, insbesondere Silber-Nanopartikel, aufweist und/oder mehrlagig auf die Beschichtung aufgebracht ist.

5. Substrat nach einem der Ansprüche 1 bis 4, **dadurch gekennzeichnet, dass** die elektrisch leitenden Fasern im Gewebe so zueinander parallel verlaufen, dass zwischen zwei benachbarten der elektrisch leitenden Fasern 1 bis 600, bevorzugt 2 bis 10, der nicht-leitenden Fasern verlaufen und/oder ein Abstand zwischen zwei benachbarten der elektrisch leitenden Fasern zwischen 0,2mm und 200mm, bevorzugt zwischen 0,5mm und 2,0mm, beträgt.

6. Flächige optoelektronische Vorrichtung, insbesondere organische optoelektronische Vorrichtung, bei welcher mindestes eine flächige Elektrode durch das Elektrodensubstrat nach einem der Ansprüche 1 bis 5 realisiert ist.

7. Verfahren zum Herstellen eines Elektrodensubstrats, insbesondere Substrat nach einem der Ansprüche 1 bis 5, **gekennzeichnet durch** die Schritte:
- Vorsehen eines zumindest nicht-leitende, transparente Fasern (50) aufweisenden Gewebes,
- Vorsehen einer Mehrzahl von sich parallel zueinander und zumindest auf einer Flachseite des Gewebes erstreckenden elektrisch leitenden, bevorzugt metallischen, Fasern (56), wobei die elektrisch leitenden Fasern im Gewebe in nur einer der Geweberichtungen, bevorzugt in der Schussrichtung, verlaufen und eine Gewebebindung der elektrisch leitenden Fasern des Gewebes so eingerichtet ist, dass zum Realisieren der hervorstehenden Abschnitte die Fasern, insbesondere in der Art einer Körperbindung, mindestens 2, bevorzugt zwischen 3 und 6, quer verlaufende der nicht-leitenden Fasern übergreifen,
- Einbetten des Gewebes sowie der elektrisch leitenden Fasern in eine Beschichtung (52) aus einem transparenten, elektrisch nicht-leitenden Polymermaterial, welches auf einer transparenten, polymeren, elektrisch nicht-leitenden Trägerfolie aufgebracht ist, so, dass auf einer Seite der Beschichtung Abschnitte der leitenden Fasern aus dem nicht-leitenden Polymermaterial der Beschichtung hervorstehen und/oder freigelegt sind,
- Abtragen von aus dem nicht-leitenden Polymermaterial der Beschichtung hervorstehendem Material, insbesondere **durch** Schleifen und/oder Polieren, sodass zumindest abschnittsweise die elektrisch leitenden Fasern plane Kontaktflächen ausbilden, wobei bevorzugt die Kontaktflächen in einer Ebene mit einer planen Oberfläche der nicht-leitenden Polymerbeschichtung liegen, und
- Beschichten der Beschichtung aus dem nicht-leitenden Polymermaterial sowie der Kontaktflächen mit einer transparenten und elektrisch leitenden Leitbeschichtung (58).

8. Verwendung der Substrate nach einem der Ansprüche 1-7 in optoelektronischen Anwendungen, insbesondere OLED, OPV, Displays, Touch-screens.

## Claims

1. An electrode substrate for an optoelectronic device with
a fabric (10) having electrically conducting fibres (14, 56), and non-conducting (12, 50), and transparent fibres,
and a coating (16, 52) implemented in a transparent, electrically non-conducting polymer material, **characterised in that**,
the coating is extensively provided with a transparent and electrically conducting conductive coating (26, 28, 58), such that for purposes of making electrical contacts the protruding, i.e. exposed sections interact with the conductive coating, in particular engage with and/or protrude into the conductive coating, and/or form a planar contact area for the conductive coating, wherein the conductive coating has a coating thickness that is less than a diameter, in particular an average diameter, of the electrically conducting and electrically non-conducting fibres of the fabric,
the electrically conducting fibres in the fabric run in only one of the directions of the fabric, preferably in the weft direction,
and a weave of the electrically conducting fibres of the fabric is established such that for purposes of implementing the protruding sections, the fibres, in particular in the form of a twill weave, cross over at least 2, preferably between 3 and 6, of the transverse running non-conducting fibres,
the fabric is embedded into the coating such that, on at least one side of the coating, sections (20, 22, 56) of the conducting fibres protrude out of, and/or are exposed from, the non-conducting polymer material of the coating,
and the coating is applied onto a polymeric, electrically non-conducting and transparent supporting film, which, in terms of the fabric, lies opposite to the conductive coating applied on one side.

2. The substrate in accordance with Claim 1, **characterised in that**, the ratio of the coating thickness of the conductive coating referred to the diameter of the fibres is less than 1:10, preferably less than 1:100.

3. The substrate in accordance with Claim 1 or 2, **characterised in that**, the electrically conducting fibres and/or the electrically non-conducting fibres have a diameter in the range between 10 µm and 200 µm, in particular between 20 µm and 80 µm.

4. The substrate in accordance with one of the Claims 1 to 3, **characterised in that**, the conductive coating has a transparent polymer and/or a transparent oxide, carbon nano-tubes, or metal nano-particles, in particular silver nano-particles, and/or is applied in multiple layers onto the coating.

5. The substrate in accordance with one of the Claims 1 to 4, **characterised in that**, the electrically conducting fibres in the fabric run parallel to one another such that 1 to 600, preferably 2 to 10, of the non-conducting fibres run between two of the adjacent electrically conducting fibres, and/or a spacing between two of the adjacent electrically conducting fibres is between 0.2 nm and 200 mm, preferably between 0.5 mm and 2.0 mm.

6. A planar optoelectronic device, in particular an organic optoelectronic device, in which at least one planar electrode is implemented in terms of the electrode substrate in accordance with one of the Claims 1 to 5.

7. A method for the manufacture of an electrode substrate, in particular a substrate in accordance with one of the Claims 1 to 5,
**characterised by** the steps:
- Provision of a fabric having at least non-conducting, transparent fibres (50),
- Provision of a multiplicity of electrically conducting, preferably metallic, fibres (56) extending parallel to one another and on at least one planar side of the fabric, wherein the electrically conducting fibres in the fabric run in only one of the directions of the fabric, preferably in the weft direction, and a weave of the electrically conducting fibres of the fabric is established such that for purposes of implementing the protruding sections, the fibres, in particular in the form of a twill weave, cross over at least 2, preferably between 3 and 6, of the transverse running non-conducting fibres,
- Embedding of the fabric and the electrically conducting fibres into a coating (52) of a transparent, electrically non-conducting polymer material, which is applied onto a polymeric, electrically non-conducting supporting film, such that on one side of the coating, sections of the conducting fibres protrude out of, and/or are exposed from, the non-conducting polymer material of the coating,
- Removal of material protruding out of the non-conducting polymer material of the coating, in particular by means of grinding and/or polishing, so that in at least some sections the electrically conducting fibres form planar contact areas, wherein the contact areas preferably lie in a plane with a planar surface of the non-conducting polymer coating, and
- Coating of the coating of the non-conducting polymer material and the contact areas with a transparent and electrically conducting conductive coating (58).

8. Use of the substrate in accordance with one of the Claims 1-7 in optoelectronic applications, in particular OLEDs, OPVs, displays, touchscreens.

## Revendications

1. Substrat d'électrode pour un dispositif optoélectronique, comprenant un tissu (10) comprenant des fibres électriquement conductrices (14 ; 56), ainsi que non conductrices (12 ; 50) et transparentes, et un revêtement (16 ; 52) réalisé en un matériau polymère transparent, électriquement non conducteur, **caractérisé en ce que** le revêtement est muni sur une grande partie de sa surface d'un revêtement conducteur transparent et électriquement conducteur (26, 28, 58), de sorte que les sections dépassant ou exposées interagissent avec le revêtement conducteur pour former des contacts électriques, notamment entrent en prise et/ou pénètrent dans le revêtement conducteur et/ou forment une surface de contact plane pour le revêtement conducteur, le revêtement conducteur présentant une épaisseur de couche qui est inférieure à un diamètre, notamment un diamètre moyen, des fibres électriquement conductrices ou électriquement non conductrices du tissu, les fibres électriquement conductrices n'étant orientées dans le tissu que dans un des sens du tissu, de préférence dans le sens de la trame, et une armure des fibres électriquement conductrices du tissu est agencée de sorte que, pour réaliser les sections dépassant, les fibres croisent perpendiculairement au moins 2, de préférence entre 3 et 6, des fibres non conductrices, notamment sous la forme d'une armure serge, le tissu étant incorporé dans le revêtement de sorte qu'au moins sur un côté du revêtement, des sections (20 ; 22 ; 56) des fibres conductrices dépassent du matériau polymère non conducteur du revêtement et/ou soient exposées,
et le revêtement étant appliqué sur un film support polymère, électriquement non conducteur et transparent, qui fait face au revêtement conducteur appliqué d'un côté, par rapport au tissu.

2. Substrat selon la revendication 1, **caractérisé en ce que** le rapport entre l'épaisseur de couche du revêtement conducteur et le diamètre des fibres est inférieur à 1:10, de préférence inférieur à 1:100.

3. Substrat selon la revendication 1 ou 2, **caractérisé en ce que** les fibres électriquement conductrices et/ou les fibres électriquement non conductrices présentent un diamètre dans la plage comprise entre 10 µm et 200 µm, notamment entre 20 µm et 80 µm.

4. Substrat selon l'une quelconque des revendications 1 à 3, **caractérisé en ce que** le revêtement conducteur comprend un polymère transparent et/ou un oxyde transparent, des nanotubes de carbone ou des nanoparticules métalliques, notamment des nanoparticules d'argent, et/ou est appliqué en plusieurs couches sur le revêtement.

5. Substrat selon l'une quelconque des revendications 1 à 4, **caractérisé en ce que** les fibres électriquement conductrices sont parallèles les unes aux autres dans le tissu de sorte que 1 à 600, de préférence 2 à 10, fibres non conductrices passent entre deux fibres électriquement conductrices voisines et/ou qu'une distance entre deux fibres électriquement conductrices voisines soit comprise entre 0,2 mm et 200 mm, de préférence entre 0,5 mm et 2,0 mm.

6. Dispositif optoélectronique plan, notamment dispositif optoélectronique organique, dans lequel au moins une électrode plane est réalisée par le substrat d'électrode selon l'une quelconque des revendications 1 à 5.

7. Procédé de fabrication d'un substrat d'électrode, notamment d'un substrat selon l'une quelconque des revendications 1 à 5, **caractérisé par** les étapes suivantes :
- la préparation d'un tissu comprenant au moins des fibres non conductrices transparentes (50),
- la préparation d'une pluralité de fibres électriquement conductrices (56), de préférence métalliques, parallèles les unes aux autres et s'étendant au moins sur une surface plane du tissu, les fibres électriquement conductrices n'étant orientées que dans un sens du tissu, de préférence dans le sens de la trame, et une armure des fibres électriquement conductrices du tissu étant agencée de sorte que, pour réaliser les sections dépassant, les fibres croisent perpendiculairement au moins 2, de préférence entre 3 et 6, des fibres non conductrices, notamment sous la forme d'une armure serge,
- l'incorporation du tissu et des fibres électriquement conductrices dans un revêtement (52) en un matériau polymère transparent, électriquement non conducteur, qui est appliqué sur une feuille support transparente, polymère, électriquement non conductrice, de sorte que sur un côté du revêtement, des sections des fibres conductrices dépassent du matériau polymère non conducteur du revêtement et/ou soient exposées,
- l'ablation du matériau dépassant du matériau polymère non conducteur du revêtement, notamment par meulage et/ou polissage, de sorte que les fibres électriquement conductrices forment au moins en sections des surfaces de contact planes, les surfaces de contact se trouvant de préférence dans un plan avec une surface plane du revêtement polymère non conducteur, et
- le revêtement du revêtement en matériau polymère non conducteur et des surfaces de contact avec un revêtement conducteur transparent et électriquement conducteur (58).

8. Utilisation des substrats selon l'une quelconque des revendications 1 à 7 dans des applications optoélectroniques, notamment des OLED, des OPV, des écrans, des écrans tactiles.
